## Europäisches Patentamt

## European Patent Office

## Office européen des brevets

(19)

(11) Veröffentlichungsnummer: **0 124 064**
A1

(12) ## EUROPÄISCHE PATENTANMELDUNG

(21) Anmeldenummer: **84104579.2**

(22) Anmeldetag: **24.04.84**

(51) Int. Cl.³: **C 25 D 1/10**, G 03 F 7/20

(30) Priorität: **29.04.83 DE 3315665**

(43) Veröffentlichungstag der Anmeldung: **07.11.84**
**Patentblatt 84/45**

(84) Benannte Vertragsstaaten: **DE IT NL SE**

(71) Anmelder: **Siemens Aktiengesellschaft, Berlin und München Wittelsbacherplatz 2, D-8000 München 2 (DE)**

(72) Erfinder: **Diener, Heinz, Klingerstrasse 26, D-8000 München 70 (DE)**
Erfinder: **Prasek, Jaroslav, Kandinskystrasse 27, D-8000 München 71 (DE)**

(54) **Herstellung von galvanoplastischen Flachteilen mit rotationsunsymmetrischen, kegelförmigen Strukturen.**

(57) Um galvanoplastische Flachteile mit rotations-unsymmetrischen, kegelförmigen Strukturen zu erzeugen, werden auf das mit Fotopolymer beschichtete Substrat während der Belichtung definierte Dreh- und Wippbewegungen übertragen. Dazu dient ein Taumelbelichtungsgerät, durch das die Neigung des Auflagetellers während einer kontinuierlichen Drehbewegung im 90°-Rhythmus geändert wird.

EP 0 124 064 A1

SIEMENS AKTIENGESELLSCHAFT          Unser Zeichen
Berlin und München                  VPA  83 P 1 3 1 3 E

Herstellung von galvanoplastischen Flachteilen mit rotations-unsymmetrischen, kegelförmigen Strukturen.

Die Erfindung betrifft ein Verfahren und eine Anordnung zur Herstellung von galvanoplastischen Flachteilen, bei denen das auf einem Träger aufgebrachte Fotopolymer durch eine Fotomaske mit transparenten und lichtundurchlässigen Flächen belichtet wird. Dabei dient entweder der Träger als Fotomaske, oder es wird durch eine getrennt hergestellte Fotomaske, die auf das Fotopolymer aufgelegt wird, belichtet.

Metallische Flachteile werden durch Stanzen, Funkenerosion, chemisches Ätzen oder als Galvanoplastik hergestellt. Höchste Präzision erreicht man, indem man auf einer elektrisch leitenden, glatten Oberfläche mittels UV-lichtempfindlichem Fotopolymer eine Matrize strukturiert und diese galvanisch abformt.

Auf herkömmliche Weise wird das Fotopolymer strukturiert, indem man eine Fotomaske auflegt und durch diese mittels einer im Winkel von 90° darüber angeordneten UV-Lampe belichtet. Während des Belichtungsvorganges findet dabei keine Lageveränderung der Lampe sowie des Fotopolymer/Fotomaskenpaketes statt.

Die mit dieser Methode erzielbare Auflösung in der Struktur hat aufgrund physikalisch-optischer Gesetzmäßigkeit ihre Grenzen. Man kann damit in der Regel nur ein Verhältnis von 1:1,5 - das heißt Basisfläche 1, Strukturhöhe 1,5 - erreichen. Eine Beeinflussung der Flankenform des Fotopolymers ist nur unwesentlich möglich.

Wed 1 Plr/13.4.1983

0124064

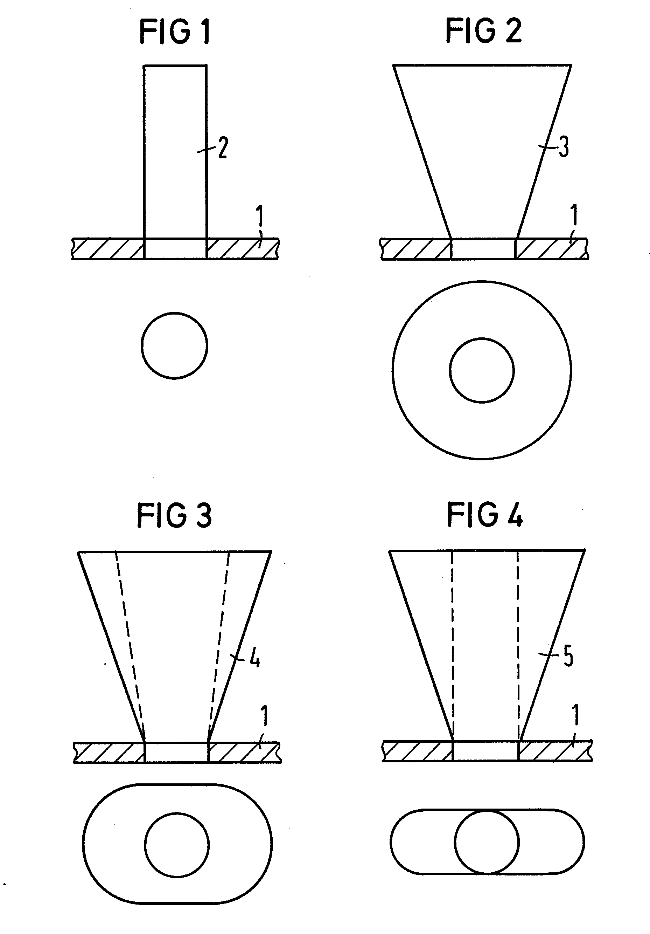

In der DE-PS 2 828 625 ist ein Verfahren beschrieben und dargestellt, das es ermöglicht, Strukturen mit einem Basis/Höhenverhältnis von 1:8 zu erzeugen. Bei diesem Verfahren wird auf einer dünnen, einseitigen Metallisierung, die auf einem lichtdurchlässigen Träger aufgebracht ist, das gewünschte Flachteilmuster erzeugt, das später als Belichtungsschablone dient. Ein auf der Schablonenseite aufgebrachter Fotoresist wird durch den Träger belichtet, in bekannter Weise entwickelt und die nicht mit Resist bedeckten Räume durch galvanische Metallabscheidung ausgefüllt. Dieses Verfahren erlaubt es, die Flankenform des Fotopolymers definiert zu beeinflussen. So lassen sich zum Beispiel sowohl zylindrische Formen (Figur 1) als auch konisch verlaufende Kegelformen (Figur 2) im Polymer einbelichten. Dieses bekannte Verfahren ermöglicht es allerdings nur, rotations-symmetrische Abbildungen zu erzeugen.

Der Erfindung liegt die Aufgabe zugrunde, mit dem eingangs genannten Verfahren rotations-unsymmetrische, kegelförmige Resiststrukturen zu erzeugen. Dies geschieht nach der Erfindung in der Weise, daß der Träger mit dem aufgebrachten Resist während der Belichtung definierten Dreh- und Wippbewegungen ausgesetzt wird. Der Vorteil dieses Verfahrens besteht darin, daß sich die Flankenformen im Fotopolymer so verändern lassen, daß zum Beispiel in x-Richtung ein anderer Durchmesser zustandekommt als in y-Richtung.

Durch anschließende galvanische Abformung sind galvanoplastische Teile herstellbar, deren Öffnungen unsymmetrisch konisch geformt sind und deren untere Öffnungen beispielsweise rund sind, während die oberen Öffnungen als Langlöcher ausgebildet sind.

Eine Anordnung zur Durchführung des Verfahrens nach der Erfindung besteht darin, daß ein Taumelbelichtungsgerät vorgesehen ist, das während der Belichtung die definierten Dreh- und Wippbewegungen auf den Trägerteller überträgt.

Mit dem Taumelbelichtungsgerät ist es möglich, die mit Fotopolymer beschichteten Substrate während der Belichtung mit UV-Licht in eine Dreh- und Wippbewegung zu versetzen. Durch eine beliebige, reproduzierbare Winkeleinstellung eines Drehtellers kann die Ausbildung des Fotopolymers in weiten Bereichen variiert werden. Ein wesentlicher Vorteil des Taumelbelichtungsgerätes besteht darin, daß damit eine gleichmäßige und präzise Ausleuchtung der Resistschicht ermöglicht wird.

Nach einer Weiterbildung der Erfindung ist die Anordnung so ausgeführt, daß sich während der kontinuierlichen Drehbewegung die Neigung des Auflagetellers im 90°-Rhythmus ändert. Dabei hat jeder um 180° versetzte Punkt des Auflagetellers während der Drehbewegung den gleichen Neigungswinkel. Auf diese Weise können galvanische Abformungen hergestellt werden, deren untere Öffnungen rund und deren obere Öffnungen als Langlöcher ausgebildet sind.

Die Erfindung wird anhand der Figuren 3 und 4 erläutert. Es zeigen jeweils in Vorder- und Draufsicht:

Figur 1 eine Galvanoplastik mit zylindrischer Form des Fotoresists,

Figur 2 eine konisch verlaufende Kegelform des Fotoresists,

Figur 3 und 4 rotations-unsymmetrische, kegelförmige Fotoresists.

Auf einem metallischen Träger 1 wird jeweils ein Negativ-Fotoresist aufgetragen. Diese Fotoschicht wird mit einer Belichtungsmaske abgedeckt und einer UV-Bestrahlung ausgesetzt. Das durch die transparenten Flächen in der Maske einfallende Licht löst in den darunterliegenden Bereichen des Fotoresists Polymerisationsreaktionen aus, die ein latentes Bild schaffen. Die nicht belichteten Teile werden abgelöst, so daß lediglich Resistreste 2 bis 5 in Form der gewünschten Konturenbegrenzung des Flachteiles auf der Trägerplatte 1 zurückbleiben.

Nach der Darstellung in der Figur 1 handelt es sich um eine zylindrische Form 2 und nach der Figur 2 um eine konisch verlaufende Kegelform 3 der Reststruktur.

Durch Anwendung des Taumelbelichtungsgerätes sind die Flankenformen 4 und 5 im Fotopolymer so verändert worden, daß in x-Richtung ein anderer Durchmesser zustandekommt als in y-Richtung. Wie aus den Draufsichten der Figuren 3 und 4 hervorgeht, sind die unteren Öffnungen jeweils rund, während die oberen Öffnungen als Langlöcher ausgebildet sind. Der Unterschied zwischen Figur 3 und 4 besteht lediglich darin, daß die Ausdehnungen in der y-Richtung bei der Figur 3 verschieden sind, während nach der Darstellung in der Figur 4 die Breite des Langloches sich mit dem Radius der unteren Öffnung deckt.

3 Patentansprüche
4 Figuren

0124064

83 P 1 3 1 3 E

Patentansprüche

1. Verfahren zur Herstellung von galvanoplastischen Flachteilen, bei denen das auf einem Träger aufgebrachte Fotopolymer durch eine Fotomaske mit transparenten und lichtundurchlässigen Flächen belichtet wird, d a d u r c h g e k e n n z e i c h n e t , daß zur Erzeugung von rotations-unsymmetrischen, kegelförmigen Reststrukturen (Figur 3 und 4) der Träger mit dem aufgebrachten Resist während der Belichtung definierten Dreh- und Wippbewegungen ausgesetzt wird.

2. Anordnung zur Durchführung des Verfahrens nach Anspruch 1, d a d u r c h g e k e n n z e i c h n e t , daß ein Taumelbelichtungsgerät vorgesehen ist, das während der Belichtung die definierten Dreh- und Wippbewegungen auf einen Substrat-Auflageteller überträgt.

3. Anordnung nach Anspruch 2, d a d u r c h g e - k e n n z e i c h n e t , daß sich während der kontinuierlichen Drehbewegung die Neigung des Auflagetellers im 90°-Rhythmus ändert.

FIG 1

FIG 2

FIG 3

FIG 4

**Europäisches Patentamt**

**EUROPÄISCHER RECHERCHENBERICHT**

0124064

Nummer der Anmeldung

EP 84 10 4579

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| A,D | DE-B-2 828 625 (SIEMENS)<br>* Anspruch 5 *<br>--- | 1,2 | C 25 D 1/10<br>G 03 F 7/20 |
| A | FR-A-1 355 121 (GOODYEAR AIRCRAFT CORP.)<br>* Seite 2, linke Spalte, Zeilen 43-48; Seite 2, rechte Spalte, Zeilen 42-45 *<br>--- | 1,2 | |
| A | US-A-3 615 449 (GREENAWAY)<br>* Spalte 5, Zeilen 17-27 *<br>----- | 1,2 | |

RECHERCHIERTE
SACHGEBIETE (Int. Cl. 3)

C 25 D
G 03 F

Der vorliegende Recherchenbericht wurde für alle Patentansprüche erstellt.

| Recherchenort | Abschlußdatum der Recherche | Prüfer |
|---|---|---|
| DEN HAAG | 09-08-1984 | NGUYEN THE NGHIEP |